# EUROPEAN PATENT SPECIFICATION

(11) **EP 3 843 514 B1**
(45) Date of publication and mention of the grant of the patent: **06.09.2023**
(21) Application number: 18930658.2
(22) Date of filing: 23.08.2018
(51) Int. Cl.: H05K 13/00, H05K 13/02, H05K 13/08

(54) **MOBILE WORK DEVICE, MOBILE WORK MANAGEMENT SYSTEM, MOUNTING SYSTEM, AND MANAGEMENT METHOD**
MOBILE ARBEITSVORRICHTUNG, MOBILES ARBEITSMANAGEMENTSYSTEM, MONTAGESYSTEM UND MANAGEMENTVERFAHREN
DISPOSITIF DE TRAVAIL MOBILE, SYSTÈME DE GESTION DE TRAVAIL MOBILE, SYSTÈME DE MONTAGE ET PROCÉDÉ DE GESTION

(43) Date of publication of application: 30.06.2021
(73) Proprietor: Fuji Corporation, Chiryu-shi, Aichi 472-8686 (JP)
(72) Inventor: YASUI, Yoshihiro, Chiryu-shi, Aichi 472-8686 (JP)
(74) Representative: Grünecker Patent- und Rechtsanwälte PartG mbB
(86) International application number: PCT/JP2018/031148
(87) International publication number: WO 2020/039546

(56) References cited:
- WO-A1-2017/085782
- WO-A1-2017/208287
- JP-A- 2004 134 691

## Description

### Technical Field

The present specification discloses a moving work device, a moving work management device, a mounting system, and a management method.

### Background art

Conventionally, a mounting system has been proposed in which a feeder storage is placed in a production line, and an exchange robot (moving work device) is provided which moves between mounting devices and a feeder storage section and exchanges feeders between the mounting devices and the feeder storage section (see Patent Document 1, for example). In this mounting system, a feeder is exchanged by a moving work device at the time of exchanging the feeder.

US 2018/0376635 A1 relates to efficient feeder management in a mounting apparatus. Whenever the maximum feeder loading capacity of the component mounter is not exhausted, additional feeders are loaded such that when an active feeder is depleted, a backup feeder has already been loaded.

### PATENT LITERATURE

Patent Document 1: International Publication No. 2017/33268

### SUMMARY OF THE INVENTION

### Technical Problem

However, in the mounting device of Patent Document 1, the feeder can be exchanged automatically to reduce the burden on an operator, but the exchange process has not been considered in detail. In such a mounting system, it is desirable to further improve productivity.

A principal object of the present disclosure is to provide a moving work device, a moving work management device, a mounting system, and a management method capable of suppressing degradation in productivity due to component depletion.

The present disclosure has taken the following means to achieve the main object described above. The invention is defined by the features of the independent claims. Any reference to inventions or embodiments not falling within the scope of the independent claims are to be interpreted as examples useful for understanding the invention.

### BRIEF DESCRIPTION OF DRAWINGS

Fig. 1 is a schematic diagram showing an example of mounting system 10.
Fig. 2 is a diagram schematically showing a configuration of mounting device 15 and loader 18.
Fig. 3 is a diagram showing an example of information stored in storage section 43.
Fig. 4 is a flowchart showing an example of a mounting process routine.
Fig. 5 is a flowchart showing an example of an exchange standby information creation process routine.
Fig. 6 is a flowchart showing an example of a mounting process routine.
Fig. 7 is a diagram showing an example of an exchange standby process of loader 18.

### DESCRIPTION OF EMBODIMENTS

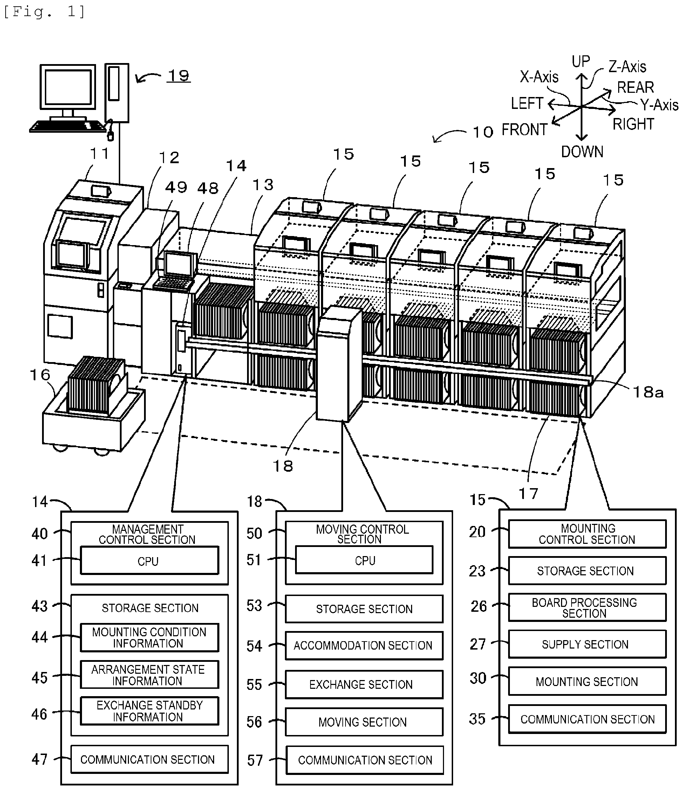

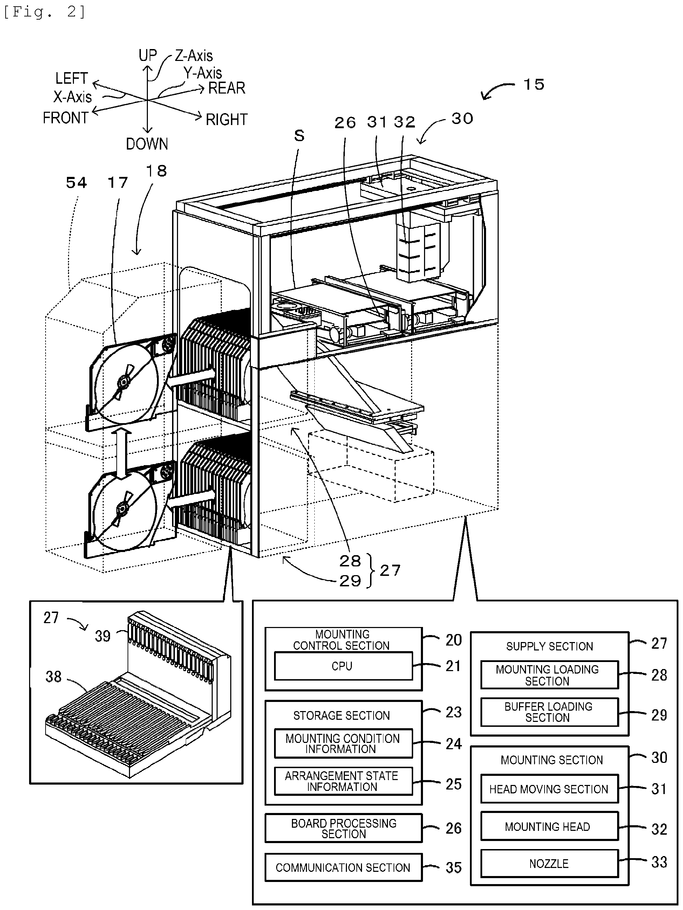

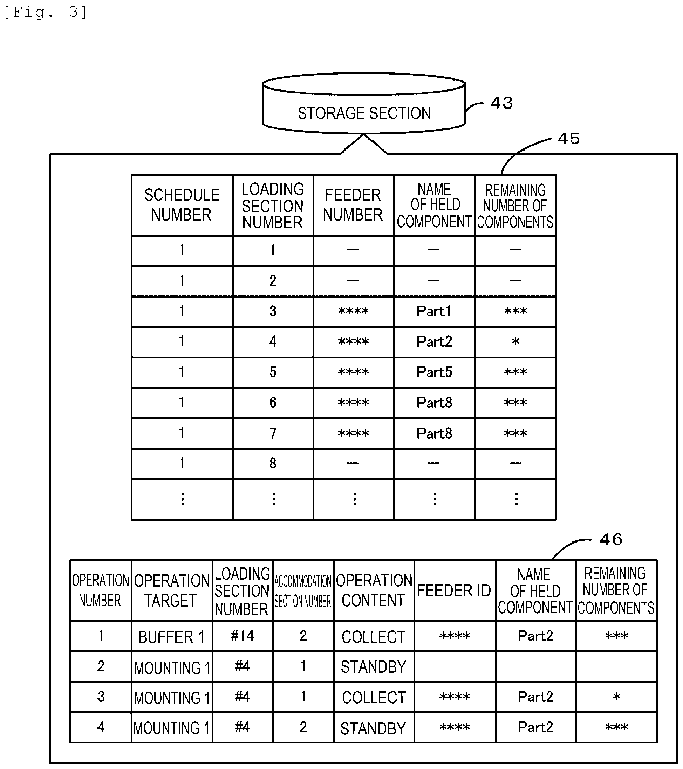

The present embodiment will be described below with reference to the drawings. Fig. 1 is a schematic diagram showing an example of mounting system 10 of the present disclosure. Fig. 2 is a diagram schematically showing a configuration of mounting device 15 and loader 18 which is a moving work device. Fig. 3 is a diagram showing an example of arrangement state information 45 and exchange standby information 46 stored in storage section 43 of management PC 14. In the present embodiment, the left-right direction (X-axis), the front-rear direction (Y-axis), and the up-down direction (Z-axis) are as shown in Figs. 1 and 2.

Mounting system 10 is configured, for example, as a production line in which devices are arranged in the conveyance direction of board S, the devices being devices for performing processes to mount components on board S which is a mounting target. Here, the mounting target is described as board S, but the present invention is not particularly limited to this as long as the object is an object on which components are mounted and may be a substrate having a three-dimensional shape. As shown in Fig. 1, mounting system 10 includes printing device 11, print inspection device 12, feeder storage section 13, management PC 14, mounting device 15, automatic conveyance vehicle 16, loader 18, host PC 19, and the like. Printing device 11 is a device for printing solder paste or the like on board S. Print inspection device 12 is a device for inspecting the state of the printed solder. Feeder storage section 13 is a storage location for storing feeder 17 used in mounting device 15. Feeder storage section 13 is provided below the conveyance device between print inspection device 12 and mounting device 15.

Mounting device 15 is a device for picking up components and mounting components on board S. Mounting device 15 includes mounting control section 20, storage section 23, board processing section 26, supply section 27, mounting section 30, and communication section 35. As shown in Fig. 2, mounting control section 20 is configured as a microprocessor centered on CPU 21 and controls the entire device. Mounting control section 20 outputs control signals to board processing section 26, supply section 27, and mounting section 30, and receives signals from board processing section 26, supply section 27, and mounting section 30. Storage section 23 stores mounting condition information 24, arrangement state information 25, and the like. Mounting condition information 24 is a production job and includes information such as information on components, the arrangement order in which components are mounted on board S, arrangement positions, and loading positions of feeders 17 from which components are picked up. Mounting condition information 24 is created by host PC 19 with an order and arrangement in which the mounting efficiency is high, transmitted from host PC 19, and stored in storage section 23. Arrangement state information 25 is the same information as arrangement state information 45 and will be described in detail later. Mounting device 15 acquires mounting condition information 24 from host PC 19 and creates arrangement state information 25 by itself. Communication section 35 is an interface for exchanging information with external devices such as management PC 14 and host PC 19.

Board processing device 26 is a unit for conveying in, transporting, securing and unloading board S at a mounting position. Board processing device 26 has a pair of conveyor belts extending in the left-right direction and spaced apart from each other in the front-rear direction in Fig. 1. Board S is conveyed by the conveyor belts.

Supply section 27 is a unit for supplying components to mounting section 30. Supply section 27 loads feeders 17 to one or more loading sections, each feeder 17 having a reel around which a tape serving as a holding member for holding components is wound. As shown in Fig. 2, supply section 27 has two upper and lower loading sections to which feeder 17 can be loaded in the front direction. The upper stage is mounting loading section 28 from which a component can be extracted by mounting section 30, and the lower stage is buffer loading section 29 from which a component cannot be extracted by mounting section 30. Here, mounting loading section 28 and buffer loading section 29 are collectively referred to as the loading section. The loading sections may be managed in module units grouping a predetermined number (e.g., 4 or 12) of feeders 17. Supply section 27 has multiple slots 38, arranged in the X-direction at predetermined intervals so that rail members of feeders 17 are inserted, and connecting portions 39 into which connectors provided at the distal ends of feeders 17 are inserted. Each feeder 17 includes a controller (not shown). The controller stores information such as tape IDs and component types included in feeder 17 and the remaining number of components. When feeder 17 is connected to connecting portion 39, the controller transmits information of feeder 17 to mounting control section 20.

Mounting section 30 is a unit for picking up components from supply section 27 and arranges the components on board S fixed to board processing section 26. Mounting section 30 includes head moving section 31, mounting head 32, and nozzle 33. Head moving section 31 includes a slider guided by guide rails and moved in the XY-direction, and a motor for driving the slider. Mounting head 32 is configured to pick up one or more components and be moved in the XY-direction by head moving section 31. Mounting head 32 is attached to the slider in a detachable manner. One or more nozzles 33 are attached to the lower face of mounting head 32 in a detachable manner. Nozzle 33 is configured to pick up components by use of negative pressure. Aside from nozzle 33, the pickup member for picking up components may be a mechanical chuck or the like that mechanically holds components.

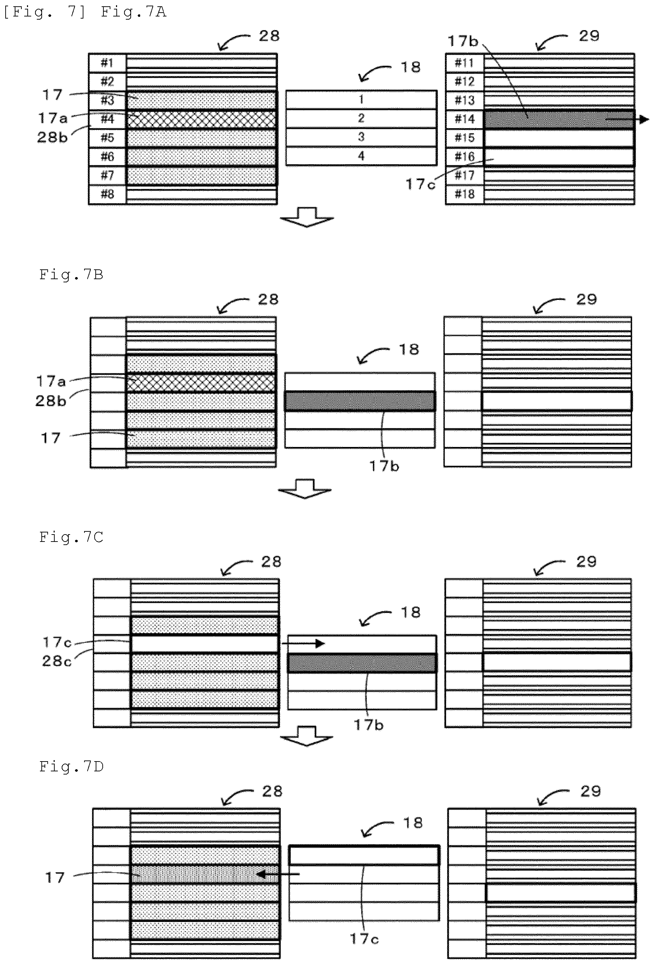

Management PC 14 is a device for managing feeder 17 and is a moving work management device for generating execution data executed by loader 18. Management PC 14 includes management control section 40, storage section 43, communication section 47, display section 48, and input device 49. Management control section 40 is configured as a microprocessor centered on CPU 41 and controls the entire device. Storage section 43 is a device such as an HDD for storing various data such as a processing program. Communication section 47 is an interface for exchanging information with external devices such as mounting device 15 and host PC 19. Display section 48 is a liquid crystal display for displaying various information. Input device 49 includes a keyboard, a mouse, and the like through which an operator inputs various commands. As shown in Figs. 1, 3, and 4, storage section 43 stores mounting condition information 44, arrangement state information 45, exchange standby information 46, and the like. Mounting condition information 44 is the same as mounting condition information 24 and is acquired from host PC 19. As shown in Fig. 3, arrangement state information 45 is information including the type and the usage state of feeder 17 (component type, remaining number of components, etc.) that is currently installed in supply section 27 of mounting device 15. Arrangement state information 45 includes the module number of supply section 27, the loading section number indicating the position of the loading section, the ID of feeder 17 loaded to the loading section, the name of the component held by feeder 17, the number of remaining components, and the like. Arrangement state information 45 is appropriately updated with current information when feeder 17 is loaded or unloaded. Exchange standby information 46 is information used to execute an exchange standby process in which, when there is feeder 17 for which there is an advance notification of component depletion, loader 18 prepares in advance feeder 17 for exchanging with the component depleted feeder 17, and puts feeder 17 for exchanging in a standby mode. Here, feeder 17 for which an advance notification of component depletion has been made is referred to as notification feeder 17a, feeder 17 for exchanging is referred to as exchange feeder 17b, and feeder 17 in which components are depleted is referred to as component depleted feeder 17c (see Fig. 7). As shown in Fig. 3, exchange standby information 46 includes information such as an operation number, which indicates the order in which an operation is performed, an operation target, a loading section number, which is the position of the loading section of supply section 27, the number of accommodation section 54 that accommodates exchange feeder 17b, the operation content of collection, standby, or loading, identification information (ID) of exchange feeder 17b that is the operation target, the name of the component held by exchange feeder 17b, and the remaining number of components thereof. For example, operation number 1 of exchange standby information 46 in Fig. 3 defines an operation for collecting exchange feeder 17b, loaded at loading section #14 of first buffer loading section 29, into second slot of accommodation section 54. Management PC 14 outputs exchange standby information 46 to loader 18 to cause loader 18 to execute the exchange standby process.

Automatic conveyance vehicle 16 is configured to automatically convey feeder 17, a member used in mounting system 10, and the like between a storage chamber (not shown) and feeder storage section 13.

Loader 18 is a moving work device and is a device that moves within a moving area at the front face of mounting system 10 (see dashed lines in Fig. 1) and automatically collects and replenishes feeders 17 of mounting device 15. Loader 18 includes moving control section 50, storage section 53, accommodation section 54, exchange section 55, moving section 56, and communication section 57. Moving control section 50 is configured as a microprocessor centered on CPU 51 and controls the entire device. Storage section 53 is an HDD or the like for storing various types of data, such as processing programs, and stores exchange standby information 46. Accommodation section 54 has an accommodation space for accommodating feeders 17. Accommodation section 54 is configured to accommodate, for example, four feeders 17. Exchange section 55 is a mechanism for moving feeder 17 in and out as well between the upper and lower levels (see Fig. 2). Exchange section 55 has a clamp for clamping feeder 17, a Y-axis slider for moving the clamp in the Y-axis direction (front-rear direction), and a Z-axis slider for moving the clamp in the Z-axis direction (up-down direction). Exchange section 55 loads and unloads feeder 17 at mounting loading section 28 and loads and unloads feeder 17 at buffer loading section 29. Moving section 56 is a mechanism for moving loader 18 in the X-axis direction (the left-right direction) along X-axis rail 18a disposed on the front face of mounting device 15. Communication section 57 is an interface for exchanging information with external devices such as management PC 14 and mounting device 15. Loader 18 outputs the current position and the contents of the executed operation to management PC 14.

Host PC 19 (see Fig. 1) is configured as a server for managing information of each device in mounting system 10. Host PC 19 includes a control section for controlling the entire device, a storage section for storing various information, and a communication section for performing bidirectional communication with external devices such as mounting system 10, automatic conveyance vehicle 16, and loader 18. Host PC 19 acquires and manages information of mounting system 10 in addition to creating and managing condition information used in the mounting of components.

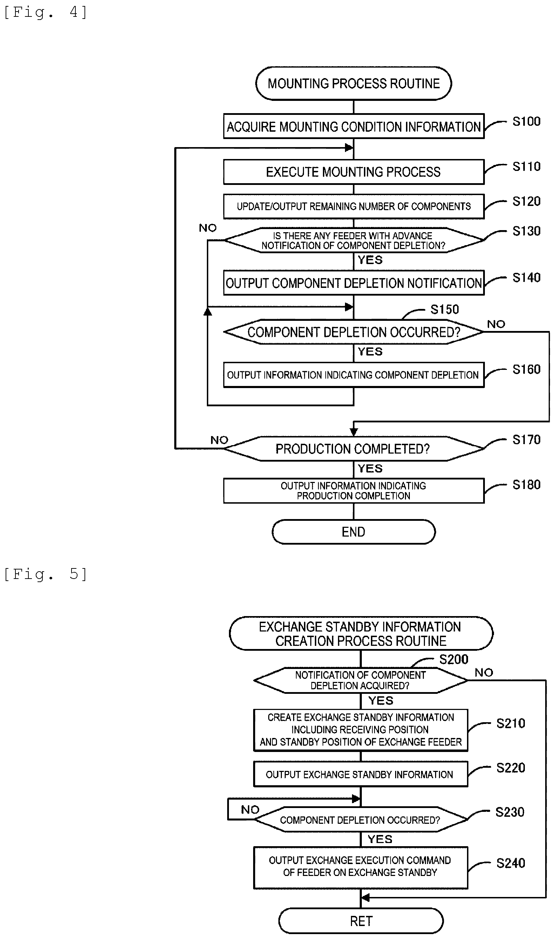

Next, among the operations of mounting system 10 of the present embodiment configured as described above, the process by which mounting device 15 mounts a component on board S will be described first. Fig. 4 is a flowchart showing an example of a mounting process routine executed by CPU 21 included in mounting control section 20 of mounting device 15. This routine is stored in storage section 23 of mounting device 15 and executed in accordance with a start instruction from an operator. When this routine is started, CPU 21 first acquires mounting condition information 24 of board S to be manufactured at this time (S100). CPU 21 acquires mounting condition information 24 from host PC 19. Next, CPU 21 executes a mounting process (S110). In the mounting process, CPU 21 causes mounting head 32 to pick up a component from feeder 17 at a predetermined position based on mounting condition information 24 and moves the component to an arrangement position of board S. Next, CPU 21 updates the number of remaining components of the used component and outputs the updated number to host PC 19 and management PC 14 (S120). Next, CPU 21 determines whether there is a feeder 17 (notification feeder 17a) for which an advance notification of component depletion has been made (S130), and when there is a notification feeder 17a, outputs an advance notification of component depletion of the corresponding feeder 17 to management PC 14 (S140). The advance notification of component depletion can be determined, for example, when the remaining number of components is less than or equal to a predetermined advance notification number, or when the time until component depletion, calculated from the remaining number of components and the number of components consumed per unit time, reaches a predetermined time period or the like. Management PC 14 which has acquired the notification of component depletion creates exchange standby information 46 for causing loader 18 to execute the exchange standby process of exchange feeder 17b and outputs exchange standby information 46 to loader 18.

After S140 or when there is no advance notification of component depletion in S130, CPU 21 determines whether there is feeder 17 in which component depletion has occurred (S150). The occurrence of component depletion can be determined by whether the remaining number of components reaches a value of 0. Further, the occurrence of component depletion can be determined by detecting a component pickup error caused by the component depletion. Further, the occurrence of component depletion can be determined by the presence/absence of a retry of one or more component pickups caused by the component depletion. Furthermore, the occurrence of component depletion can be determined by a combination of at least two of the remaining number of components, the detection of a component pickup error, and the number of retries of component pickups. CPU 21 can more reliably determine the occurrence of component depletion as the number of combinations thereof increases, or as the number of pickup errors and the number of retries of component pickups increase. When there is feeder 17 in which component depletion has occurred, CPU 21 outputs information indicating that component depletion has occurred to management PC 14 (S160) and executes the processes in S150 onward. That is, CPU 21 stands by until an affirmative determination is made in S150 resulting from component depleted feeder 17c having been exchanged with new exchange feeder 17b. Management PC 14 that has acquired the information of the component depletion occurrence creates an exchange execution command for exchanging component depleted feeder 17c with exchange feeder 17b and outputs the command to loader 18. After S160 or in a case where there is no component depletion in S150, CPU 21 determines whether production of board S is completed (S170) and executes the processes in S110 onward if production is not completed. On the other hand, when production is completed in S170, CPU 21 outputs information indicating that production is completed to host PC 19 or management PC 14 (S180) and terminates this routine.

Next, the process for creating the work contents of loader 18 performed by management PC 14 will be described. In particular, a process will be described for creating information that causes feeder 17 for exchanging to move to the vicinity of feeder 17 in which component depletion will occur before the component depletion occurs and causes loader 18 to stand by for exchanging. Fig. 5 is a flowchart showing an example of an exchange standby information creation process routine executed by CPU 41 included in management control section 40 of management PC 14. This routine is stored in storage section 43 of management PC 14 and repeatedly executed after the booting up of mounting system 10. When this routine is started, CPU 41 first determines whether an advance notification of component depletion has been acquired (S200). The advance notification of component depletion may be created by mounting device 15 or host PC 19 and transmitted to management PC 14, or management PC 14 may directly or indirectly acquire the number of remaining components from mounting device 15 and CPU 41 may create and acquire the advance notification in the manner described above. If an advance notification of component depletion has not been acquired, CPU 41 terminates the routine.

On the other hand, if the component depletion notification is acquired in S200, CPU 41 creates exchange standby information 46 including the position and the exchange standby position of notification feeder 17a for which the component depletion notification was made, the receiving position and the operation order of exchange feeder 17b corresponding to notification feeder 17a, and the like (S210). CPU 41 acquires the position of notification feeder 17a from the information included in the advance notification of component depletion. Further, CPU 41 searches and acquires the location where exchange feeder 17b is stored based on arrangement state information 45. Exchange feeder 17b is assumed to be present in any one of mounting loading section 28, buffer loading section 29, and feeder storage section 13 that are not used. Further, CPU 41 sets an operation order of acquiring (collecting), standing by, and exchanging with component depleted feeder 17c of exchange feeder 17b (see Fig. 3). At this time, CPU 51 sets the accommodation position of accommodation section 54 between component depleted feeder 17c and notification feeder 17a so as to accommodate exchange feeder 17b next to the position at which component depleted feeder 17c is collected. Next, the created exchange standby information 46 is outputted to loader 18 (S220). Loader 18, which has received exchange standby information 46, executes the exchange standby process based on exchange standby information 46. Subsequently, CPU 41 determines whether component depletion of notification feeder 17a has occurred (S230), and stands by if component depletion has not occurred. On the other hand, if component depletion has occurred, CPU 41 outputs the exchange execution command of feeder 17 standing by to be exchanged to loader 18 (S240) and terminates this routine.

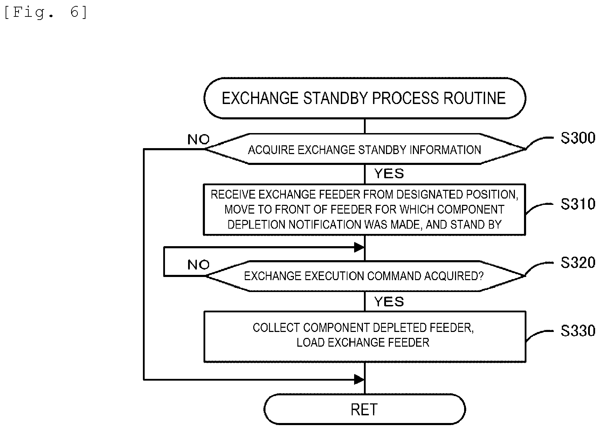

Next, the exchange standby process executed by loader 18 which has acquired exchange standby information 46 will be described. Fig. 6 is a flowchart showing an example of a feeder exchange process routine executed by CPU 51 included in moving control section 50 of loader 18. This routine is stored in storage section 53 of loader 18 and repeatedly executed after the booting up of loader 18. When this routine is started, CPU 51 first determines whether exchange standby information 46 has been acquired (S300). If exchange standby information 46 has not been acquired, CPU 51 terminates the routine. On the other hand, if exchange standby information 46 has been acquired, CPU 51 receives (collects) exchange feeder 17b from the position specified in exchange standby information 46, moves accommodation section 54 to a position in front of notification feeder 17a where component depletion is predicted to occur and causes accommodation section 54 to stand by (S310). Next, CPU 51 determines whether the exchange execution command has been acquired (S320) and stands by if the exchange execution command has not been acquired. CPU 51 acquires exchange standby information 46 and the exchange execution command from management PC 14 but may acquire any of them from host PC 19 and mounting device 15. On the other hand, if the exchange execution command has been acquired, CPU 51 collects component depleted feeder 17c in accommodation section 54, executes a process for causing mounting loading section 28 to load exchange feeder 17b (S330) and terminates this routine.

Fig. 7 is a diagram showing an example of the exchange standby process of loader 18, in which Fig. 7A is a diagram showing, upon advance notification of component depletion, loader 18 receiving exchange feeder 17b, Fig. 7B is a diagram showing loader 18 standing by for exchanging in front of notification feeder 17a, Fig. 7C is a diagram showing the collecting of component depleted feeder 17c, and Fig. 7D is a diagram showing the loading of exchange feeder 17b. Fig. 7 shows the content of executing the exchange standby process prescribed in exchange standby information 46 at the current arrangement position of feeder 17 prescribed in arrangement state information 45 shown in Fig. 3. In the exchange standby process, CPU 51 of loader 18 executes the operations specified by operation numbers 1 to 4 based on the content of exchange standby information 46. That is, CPU 51 moves loader 18 to the front of exchange feeder 17b disposed in the current buffer loading section 29, receives exchange feeder 17b (see Fig. 7A), and accommodates exchange feeder 17b in accommodation section 54. Next, loader 18 is moved to the position where notification feeder 17a (notification loading section 28b) and the empty slot of accommodation section 54 face each other and loader 18 is placed on standby until notification feeder 17a becomes component depleted (Fig. 7B). At this time, exchange feeder 17b is located next to notification feeder 17a. Subsequently, when component depletion of advance notification feeder 17a occurs, CPU 51 collects component depleted feeder 17c in the empty slot of accommodation section 54 (see Fig. 7C). CPU 51 then moves exchange feeder 17b to a position facing component depletion loading section 28c and loads exchange feeder 17b to component depletion loading section 28c (Fig. 7D). Thereafter, loader 18 moves component depleted feeder 17c to buffer loading section 29 or feeder storage section 13. In this way, when component depletion occurs in mounting device 15, loader 18 that is in standby is capable of exchanging immediately.

Here, the correspondence between the constituent elements of the present embodiment and the constituent elements of the present disclosure will be specified. Mounting device 15 of the present embodiment corresponds to a mounting device, management PC 14 corresponds to a moving work management device, and loader 18 corresponds to a moving work device. In addition, supply section 27 corresponds to a supply section, mounting section 28 and buffer mounting section 29 correspond to a mounting section, mounting section 30 corresponds to a mounting section, and mounting control section 20 corresponds to a mounting control section. In addition, accommodation section 54 corresponds to an accommodation section, and moving control section 50 corresponds to a moving control section. Further, mounting condition information 44 corresponds to mounting condition information, standby feeder 17b corresponds to a feeder for exchanging, exchange standby information 46 corresponds to exchange standby information, and management control section 40 corresponds to a management control section. In addition, feeder storage section 13 corresponds to a storage section, the tape corresponds to a holding member, and board S corresponds to a mounting target.

In mounting system 10 described above, after loader 18 acquires component depletion notification for notifying in advance of the component depletion of feeder 17, exchange feeder 17b is received by accommodation section 54 and the exchange standby process of exchange feeder 17b is executed in front of the loading section of notification feeder 17a for which the component depletion notification was issued. In mounting system 10, since the exchanging of feeder 17 can be immediately executed when component depletion occurs, it is possible to further suppress degradation in productivity due to component depletion. In addition, since moving control section 50 accommodates exchange feeder 17b next to the position where component depleted feeder 17c is collected, it is possible to further reduce the movement between the collection of component depleted feeder 17c and the loading of exchange feeder 17b, thereby further suppressing degradation in productivity due to component depletion. Further, when the notification of component depletion is acquired based on the number of remaining components, moving control section 50 can predict the component depletion of the feeder, for example, by the number of remaining components to falling below a predetermined value or the like since the exchange standby process is executed. Moreover, when the exchange execution command is acquired based on the occurrence of component depletion, moving control section 50 executes the exchange process of the feeder for exchanging standing by to be exchanged, thus making it possible to further suppress degradation in productivity due to component depletion.

It is obvious that the present disclosure is not limited to the above-described embodiments and can be implemented in various modes as long as the modes are within the technical scope of the present invention as defined by the appended claims.

For example, in the above embodiment, loader 18 accommodates exchange feeder 17b next to the position at which component depleted feeder 17c is collected, but the present invention is not particularly limited thereto, and feeder 17 may be accommodated in any slot of accommodation section 54. It is preferable that component depleted feeder 17c and exchange feeder 17b are next to each other since the moving time is shorter.

In the above embodiment, a case in which loader 18 stands by to be exchanged while one notification feeder 17a is generated and one exchange feeder 17b is accommodated has been described, but the present invention is not particularly limited thereto, loader 18 may stand by to be exchanged while multiple notification feeders 17a are generated and multiple exchange feeders 17b are accommodated. Specifically, with component depleted feeder 17c capable of being accommodated, moving control section 50 may cause multiple exchange feeders 17b to be accommodated in accommodation section 54, and cause loader 18 to move to the front of the loading section and stand by to be exchanged in accordance with the order based on component depletion notifications. Management control section 40 may create such exchange standby information 46. In mounting system 10, since the collecting and exchanging of multiple component depleted feeders 17c can be continuously performed, it is possible to further suppress degradation in productivity due to component depletion. At this time, moving control section 50 may cause accommodation section 54 to accommodate multiple exchange feeders 17b so that the position where exchange feeder 17b is loaded becomes the collecting position for the next component depleted feeder 17c, and the position next to it becomes the position of the next exchange feeder 17b. Since loader 18 can further shorten the movement of feeders at the time of exchanging, it is possible to further suppress degradation in productivity due to component depletion.

In the above embodiment, the processes of S130 to S160 for notifying of a component depletion or determining the occurrence of component depletion is described as being performed by mounting device 15, but the present invention is not particularly limited to this, and the processes may be performed by another device, for example, management PC 14, host PC 19, or even loader 18. Management PC 14 may obtain the determination result from the device that has performed the determination process or may obtain the determination result by performing the determination process in management control section 40 after obtaining the number of remaining components.

In the above embodiment, mounting system 10 includes printing device 11, print inspection device 12, feeder storage 13, management PC 14, and mounting device 15, but the present invention is not particularly limited thereto, and one or more of the above devices may be omitted or other devices may be added.

In the above embodiment, management PC 14 installed in feeder storage section 13 has been described as managing loader 18, but the present invention is not particularly limited to this and may be provided with this function in other devices such as host PC 19, mounting device 15, and loader 18, for example. In the above embodiment, loader 18 is configured to load or collect feeder 17, but the present invention is not particularly limited thereto, and may be configured so that automatic conveyance vehicle 16 loads and collects feeder 17.

In the above embodiment, the present disclosure is applied to a mode of mounting system 10, but the present disclosure may be applied to management PC 14 (moving work management device) or loader 18 (moving work device), or may be applied to the management method of a moving work device.

The moving work device, the moving work management device, the mounting system, and the management method of the present disclosure may be configured as follows. For example, in the mobile work device of the present disclosure, the accommodation section may accommodate multiple feeders, and the moving control section may cause the feeder for exchanging to be accommodated next to the position for collecting the component depleted feeder. Since the moving working device can reduce the movement between collecting and loading the feeder for exchanging, it is possible to suppress degradation in productivity due to component depletion.

In the moving work device of the present disclosure, the accommodation section may be configured to accommodate multiple feeders for exchanging; with the feeders to be collected being capable of being accommodated, the moving control section may cause multiple feeders for exchanging to be accommodated in the accommodation section; and the moving control section causes a moving work device to be moved to the front of the loading section and stand by for exchanging in accordance with the order based on advance notifications of component depletion. Since the moving work device can collect and exchange multiple feeders, it is possible to further suppress degradation in productivity due to component depletion. In the moving work device, the moving control section may cause the accommodation section to accommodate multiple exchange feeders so that the positions where the exchange feeders are loaded become the collecting positions for the next feeders, and the positions next to them become the collecting positions for the next exchange feeders. Since the moving work device can shorten the movement of feeders at the time of exchanging, it is possible to further suppress degradation in productivity due to component depletion.

In the moving work device of the present disclosure, the moving control section may execute the exchange standby when acquiring the advance notification of component depletion based on the remaining number of components. In this moving work device, for example, it is possible to predict component depletion of a feeder based on whether the remaining number of components falls below a predetermined value. Further, the movement control section may execute the exchange standby process when it acquires a notification of component depletion based on one or more of the remaining number of components, the pickup error of the component, and the retry of the component pickup.

In the moving work device of the present disclosure, the moving control section executes an exchange process of an exchange feeder standing by to be exchanged when acquiring an exchange execution command based on the occurrence of component depletion. The moving work device can detect component depletion in the feeder, for example, by whether the remaining number of components reaches a value of zero. The moving control section is preferable from the viewpoint of detection accuracy to detect component depletion by a combination of two or more parameters, such as a combination of the remaining number of components and the component pickup error, a combination of the remaining number of components and the number of component pickup retries, and the like.

The moving work management device of the present disclosure is a moving work management device used in a mounting system comprising: a mounting section configured to mount a component on a mounting target; a supply section having a loading section configured to load a feeder including a holding member for holding the component; a mounting device provided with a mounting control section configured to cause the mounting section to pick up the component from the feeder; an accommodation section configured to accommodate the feeder; and
a moving work device provided with a moving control section configured to move the feeder to collect the feeder from or load the feeder to the supply section;
wherein the moving work management device comprises: a management control section configured to receive the feeder for exchanging in the accommodation section after acquiring a component depletion notification for notifying in advance of a component depletion of a feeder, cause the feeder for exchanging to stand by, to be exchanged, in front of a loading section of the feeder in which there was an advance notification of component depletion, and output the created exchange standby information to the moving work device.

In this moving work management device, similarly to the moving work device described above, since the moving work device can immediately execute exchange of the feeder when component depletion occurs, it is possible to suppress degradation in productivity due to component depletion.

In the moving work management device of the present disclosure, the management control section may acquire the remaining number of components as an advance notification of component depletion. In this moving work management device, it is possible, for example, to predict component depletion of a feeder based on whether the remaining number of components falls below a predetermined value.

In the moving work management device of the present disclosure, when determining the occurrence of a component depletion, the management control section may output to the moving work device an exchange execution command for causing the moving work device to execute an exchange process of the exchange feeder standing by for exchange. In this moving work management device, it is possible, for example, to detect component depletion of a feeder based on the remaining number of components reaching a value of zero.

The mounting system of the present disclosure is a mounting system comprising: a mounting device provided with a mounting section configured to mount a component on a mounting target, a supply section having a loading section for loading a feeder comprising a holding member configured to hold the component, and a mounting control section configured to cause the mounting section to pick up the component from the feeder; any of the moving work devices described above; and any of the moving work management devices described above.

In this mounting system, similarly to the moving work device described above, since the moving work device can immediately execute exchange of the feeder when component depletion occurs, it is possible to suppress degradation in productivity due to component depletion.

The management method of the present disclosure is a management method used in a mounting system comprising: a mounting section configured to mount a component on a mounting target; a supply section having a loading section configured to load a feeder including a holding member for holding the component; a mounting device provided with a mounting control section configured to cause the mounting section to pick up the component from the feeder; an accommodation section configured to accommodate the feeder; and a moving work device provided with a moving control section configured to move the feeder to collect the feeder from or load the feeder to the supply section; wherein the management method comprises: (a) a step of receiving the feeder for exchanging in the accommodation section after acquiring a component depletion notification for notifying in advance of a component depletion of a feeder, and causing the feeder for exchanging to stand by, to be exchanged, in front of a loading section of the feeder in which there was an advance notification of component depletion, and (b) a step of outputting the created exchange standby information to moving work device.

In this management method, similarly to the moving work device described above, since the moving work device can immediately execute exchange of the feeder when component depletion occurs, it is possible to suppress degradation in productivity due to component depletion. In this management method, various modes of the above-described moving work device may be employed or steps for achieving each function of the above-described moving work device may be added.

### Industrial applicability

The present disclosure is applicable to the technological field of devices for picking up and mounting components.

### Reference Signs List

10 Mounting system, 11 Printing device, 12 Print inspection device, 13 Feeder storage section, 14 Management PC, 15 Mounting device, 16 Automatic conveyance vehicle, 17 Feeder, 17a Notification feeder, 17b Exchange feeder, 17c Component depleted feeder, 18 Loader, 18a X-axis rail, 19 Host PC, 20 Mounting control section, 21 CPU, 23 Storage section, 24 Mounting condition information, 25 Arrangement state information, 26 Board processing section, 27 Supply section, 28 Mounting loading section, 28a Spare loading section, 28b Notification loading section, 28c Component depletion loading section, 28d Available loading section, 29 Buffer loading section, 30 Mounting section, 31 Head moving section, 32 Mounting head, 33 Nozzle, 35 Communication section, 38 Slot, 39 Connecting section, 40 Management control section, 41 CPU, 43 Storage section, 44 Mounting condition information, 45 Arrangement state information, 46 Exchange standby information, 47 Communication section, 48 Display section, 49 Input device, 50 Moving control section, 51 CPU, 53 Storage section, 54 Accommodation section, 55 Exchange section, 56 Moving section, 57 Communication section, S Board

## Claims

1. A moving work device (18) used in a mounting system (10) comprising:
a mounting section (30) configured to mount a component on a mounting target;
a supply section (27) having a loading section configured to load a feeder including a holding member for holding the component;
a mounting device (15) provided with a mounting control section configured to cause the mounting section (30) to pick up the component from the feeder; and
a moving work device (18) configured to move the feeder to collect the feeder from or load the feeder to the supply section (27);
wherein the moving work device (18) comprises:
an accommodation section (54) configured to accommodate the feeder; and
a moving control section (50)
**characterized by**
being configured to receive an exchange feeder, after acquiring a component depletion notification for notifying in advance of a component depletion of a notification feeder where component depletion is predicted to occur, for exchanging in the accommodation section (54), and cause the exchange feeder to stand by, to be exchanged, in front of a loading section of the notification feeder in which there was an advance notification of component depletion.

2. The moving work device (18) of claim 1, wherein the accommodation section (54) accommodates multiple feeders, and the moving control section (50) causes the exchange feeder to be accommodated next to the position at which the component depleted notification feeder is to be collected.

3. The moving work device (18) of claim 1 or 2, wherein the accommodation section (54) is configured to accommodate multiple exchange feeders; and the moving control section (50) causes multiple exchange feeders to be accommodated in the accommodation section (54), wherein the notification feeders to be collected are capable of being accommodated, and the moving control section (50) causes a moving work device (18) to be moved to the front of the loading section and stand by for exchanging in accordance with the order based on advance notifications of component depletion.

4. The moving work device (18) of any one of claims 1 to 3, wherein the moving control section (50) executes an exchange process of an exchange feeder standing by to be exchanged when acquiring an exchange execution command based on the occurrence of component depletion.

## Patentansprüche

1. Mobile Arbeitsvorrichtung (18), die in einem Montagesystem (10) verwendet wird, umfassend:
einen Montageabschnitt (30), der konfiguriert ist zum Montieren eines Bauelements an einem Montageziel,
einen Zuführabschnitt (27), der einen Ladeabschnitt aufweist, der konfiguriert ist zum Laden eines Zuführers, der ein Halteglied für das Halten des Bauelements umfasst,
eine Montagevorrichtung (15), die mit einem Montagesteuerabschnitt versehen ist, der konfiguriert ist zum Veranlassen, dass der Montageabschnitt (30) das Bauelement von dem Zuführer aufgreift, und
eine mobile Arbeitsvorrichtung (18), die konfiguriert ist zum Bewegen des Zuführers für das Sammeln des Zuführers von oder Laden des Zuführers zu dem Zuführabschnitt (27),
wobei die mobile Arbeitsvorrichtung (18) umfasst:
einen Aufnahmeabschnitt (54), der konfiguriert ist zum Aufnehmen des Zuführers, und
einen mobilen Steuerabschnitt (50),
**gekennzeichnet durch:**
Aufnehmen eines Austausch-Zuführers, nach dem Erhalten einer Bauelementverbrauchsnachricht für das frühzeitige Benachrichtigen über den Fortschritt eines Bauelementverbrauchs, in der ein vollständiger Verbrauch des Bauelements vorausgesagt wird, für einen Austausch in dem Aufnahmeabschnitt (54), und Veranlassen, dass der Austausch-Zuführer vor dem Ladeabschnitt des Zuführers, auf den sich die frühzeitige Bauelementverbrauchsnachricht bezieht, für einen Austausch bereitsteht.

2. Mobile Arbeitsvorrichtung (18) nach Anspruch 1, wobei mehrere Zuführer in dem Aufnahmeabschnitt (54) aufgenommen sind und wobei die mobile Steuerabschnitt (50) veranlasst, dass der Austausch-Zuführer neben der Position, an welcher der Zuführer, auf den sich die Bauelementverbrauchsnachricht bezieht, zu sammeln ist, aufgenommen wird.

3. Mobile Arbeitsvorrichtung (18) nach Anspruch 1 oder 2, wobei der Aufnahmeabschnitt (54) konfiguriert ist zum Aufnehmen von mehreren Austausch-Zuführern und wobei der mobile Steuerabschnitt (50) veranlasst, dass mehrere Austausch-Zuführer in dem Aufnahmeabschnitt (54) aufgenommen werden, wobei die zu sammelnden Zuführer, auf die sich die Benachrichtigung bezieht, aufgenommen werden können, und wobei der mobile Steuerabschnitt (50) gemäß einer Reihenfolge basierend auf vorausgehenden Benachrichtigungen des Bauelementverbrauchs veranlasst, dass eine mobile Arbeitsvorrichtung (18) vor den Ladeabschnitt bewegt wird und für einen Austausch bereitsteht.

4. Mobile Arbeitsvorrichtung (18) nach einem der Ansprüche 1 bis 3, wobei der mobile Steuerabschnitt (50) einen Austauschprozess für einen für einen Austausch bereitstehenden Austausch-Zuführer ausführt, wenn ein Austausch-Ausführungsbefehl basierend auf dem Auftreten eines Bauelementverbrauchs erhalten wird.

## Revendications

1. Dispositif de travail mobile (18) utilisé dans un système de montage (10) comprenant :
une section de montage (30) configurée pour monter un composant sur une cible de montage ;
une section d'approvisionnement (27) présentant une section de chargement configurée pour charger un chargeur incluant un élément de maintien pour maintenir le composant ;
un dispositif de montage (15) doté d'une section de contrôle de montage configurée pour que la section de montage (30) prélève le composant à partir du chargeur ; et
un dispositif de travail mobile (18) configuré pour déplacer le chargeur pour collecter le chargeur à partir de la ou charger le chargeur dans la section d'approvisionnement (27) ;
dans lequel le dispositif de travail mobile (18) comprend :
une section d'accueil (54) configurée pour accueillir le chargeur ; et
une section de contrôle de déplacement (50)
**caractérisé par**
étant configuré pour recevoir un chargeur d'échange, après acquisition d'une notification d'épuisement de composants pour notifier à l'avance d'un épuisement de composants d'un chargeur de notification où il est prévu qu'un épuisement de composants se produise, pour un échange dans la section d'accueil (54), et pour que le chargeur d'échange se mette en attente, pour être échangé, devant une section de chargement du chargeur de notification dans lequel il existait une notification à l'avance d'un épuisement de composants.

2. Le dispositif de travail mobile (18) de la revendication 1, dans lequel la section d'accueil (54) accueille plusieurs chargeurs, et la section de contrôle de déplacement (50) fait accueillir le chargeur d'échange à côté de la position sur laquelle le chargeur de notification d'épuisement de composants est à collecter.

3. Le dispositif de travail mobile (18) de la revendication 1 ou 2, dans lequel la section d'accueil (54) est configurée pour accueillir plusieurs chargeurs ; et la section de contrôle de déplacement (50) fait accueillir plusieurs chargeurs d'échange dans la section d'accueil (54), dans lequel les chargeurs de notification à collecter sont en mesure d'être accueillis, et la section de contrôle de déplacement (50) fait déplacer un dispositif de travail mobile (18) vers l'avant de la section de chargement et le fait mettre en attente pour un échange conformément à l'ordre reposant sur des notifications à l'avance d'épuisement de composants.

4. Le dispositif de travail mobile (18) d'une des revendications 1 à 3, dans lequel la section de contrôle de déplacement (50) exécute un processus d'échange d'un chargeur d'échange en attente d'être échangé lors d'une acquisition d'une commande d'exécution d'échange selon l'occurrence d'épuisement de composants.
